# EUROPÄISCHE PATENTSCHRIFT

(11) **EP 4 158 683 B1**
(45) Veröffentlichungstag und Bekanntmachung des Hinweises auf die Patenterteilung: **10.04.2024**
(21) Anmeldenummer: 20733531.6
(22) Anmeldetag: 29.05.2020
(51) Int. Cl.: H01L 21/683

(54) **VERFAHREN ZUM BONDEN UND DEBONDEN ZWEIER SUBSTRATE**
METHOD FOR BONDING AND DEBONDING TWO SUBSTRATES
PROCÉDÉ POUR COLLER ET DÉCOLLER DEUX SUBSTRATS

(43) Veröffentlichungstag der Anmeldung: 05.04.2023
(73) Patentinhaber: Thallner, Erich, 4782 St. Florian am Inn (AT)
(72) Erfinder: Thallner, Erich, 4782 St. Florian am Inn (AT)
(74) Vertreter: Schneider, Sascha
(86) Internationale Anmeldenummer: PCT/EP2020/065012
(87) Internationale Veröffentlichungsnummer: WO 2021/239253

(56) Entgegenhaltungen:
- US-A1- 2015 228 849
- US-A1- 2017 125 268
- US-A1- 2017 170 048
- US-A1- 2018 233 394

## Beschreibung

Die vorliegende Erfindung betrifft ein Verfahren zum Bonden und Debonden zweier Substrate gemäß den nebengeordneten Patentansprüchen sowie einen entsprechenden Substratstapel und entsprechende Vorrichtungen.

Die voranschreitende Miniaturisierung in beinahe allen Teilen der Mikroelektronik und Mikrosystemtechnik sorgt für eine ständige Weiterentwicklung aller Technologien, mit deren Hilfe man die Dichte aller Arten von funktionalen Einheiten auf Substraten steigern kann. Zu diesen funktionalen Einheiten gehören beispielsweise Mikrocontroller, Speicherbausteine, MEMS, alle Arten von Sensoren oder Mikrofluidbauteile.

In den letzten Jahren wurden die Techniken zur Erhöhung der lateralen Dichte dieser funktionalen Einheiten stark verbessert. In einigen Teilbereichen der Mikroelektronik oder Mikrosystemtechnik sogar so weit, dass eine weitere Steigerung der lateralen Dichte der funktionalen Einheiten nicht mehr möglich ist. In der Mikrochipherstellung wurde die maximal erreichbare Auflösungsgrenze für lithographisch herzustellenden Strukturen bereits so gut wie erreicht. Physikalische oder technologische Beschränkungen erlauben also in wenigen Jahren gar keine Steigerung der lateralen Dichte funktionaler Einheiten mehr. Die Industrie begegnet diesem Problem bereits seit einigen Jahren durch die Entwicklung von 2.5D und 3D Technologien. Mit Hilfe dieser Technologien ist es möglich, gleiche, oder sogar unterschiedlich geartete, funktionale Einheiten zueinander auszurichten, übereinander zu stapeln, sie permanent miteinander zu verbinden und durch entsprechende Leiterbahnen miteinander zu vernetzen.

Eine der Schlüsseltechnologien für die Realisierung solcher Strukturen ist das Temporärbonden. Unter Temporärbonden versteht man Verfahren, mit deren Hilfe Substrate so miteinander verbunden werden können, dass deren Trennung ohne Zerstörung der Substrate möglich ist.

Im Stand der Technik (siehe zum Beispiel US 2017/125268 A1, US 2018/233394 A1, US 2017/170048 A1, und US 2015/228849 A1) existieren mehrere Verfahren zum Debonden/Lösen zweier Substrate (Produktsubstrat und Trägersubstrat). Die meisten Verfahren verwenden sogenannte Bondingadhäsive, um eine temporäre, relativ leicht lösbare Verklebung zweier Substrate zu erreichen. Bei den Bondingadhäsiven handelt es sich meistens um Polymere, insbesondere Thermoplaste.

Es hat sich jedoch herausgestellt, dass die Verwendung von Polymeren als temporäres Bondingadhäsiv insbesondere durch die Umweltbelastung mittels Chemikalien für die Reinigung sowie die Kosten der Verbrauchsmaterialien nachteilig ist. Es ist weiterhin ein Nachteil aller polymeren temporären Bondingadhäsive, dass die Temperaturbeständigkeit weit niedriger liegt als die anderen Prozessierungstemperaturen des Produktsubstrats. Somit stellt das Temporärbonden mittels Polymeren eine technologische Begrenzung für die Bearbeitung des Produktsubstrats dar.

Es ist daher die Aufgabe der Erfindung, die im Stand der Technik aufgeführten Nachteile zumindest zum Teil zu beseitigen, insbesondere vollständig zu beseitigen. Insbesondere ist es eine Aufgabe der Erfindung, verbesserte Verfahren zum Bonden und Debonden aufzuzeigen.

Die vorliegende Aufgabe wird mit den Merkmalen der nebengeordneten Ansprüche gelöst. Vorteilhafte Weiterbildungen der Erfindung sind in den Unteransprüchen angegeben. Bei angegebenen Wertebereichen sollen auch innerhalb der genannten Grenzen liegende Werte als Grenzwerte offenbart gelten und in beliebiger Kombination beanspruchbar sein.

Die Erfindung betrifft ein Verfahren zum temporären Bonden eines Produktsubstrats mit einem Trägersubstrat, aufweisend mindestens die folgenden Schritte:
- Herstellung einer metallisierten Temporärbondschicht am Produktsubstrat und/oder am Trägersubstrat,
- Bonden des Produktsubstrats mit dem Trägersubstrat an der metallisierten Temporärbondschicht, wobei das Trägersubstrat strukturiert ausgebildet ist, wobei das Trägersubstrat Erhebungen und Kavitäten aufweist, wobei sich die Erhebungen mit dem Produktsubstrat über metallische Kontakte stabil verbinden und die Kavitäten zwischen den Erhebungen angeordnet sind.

Die Erfindung betrifft weiterhin einen Substratstapel, insbesondere hergestellt mit einem erfindungsgemäßen Verfahren, aufweisend ein Produktsubstrat und ein Trägersubstrat, wobei das Produktsubstrat und des Trägersubstrat durch eine metallisierte Temporärbondschicht verbunden sind.

Vorzugsweise handelt es sich bei der Temporärbondschicht um die einzige Schicht, die für das erfindungsgemäße Bond- bzw. Debondverfahren benutzt wird. Dadurch ergibt sich ein weiterer Vorteil zum Stand der Technik, in dem meistens mehrere Polymerschichten, eine für das Bonden und eine für das Debonden übereinander verwendet werden.

Die Erfindung betrifft weiterhin eine Vorrichtung zum temporären Bonden eines Produktsubstrats mit einem Trägersubstrat, insbesondere mit einem Verfahren nach mindestens einer der vorhergehenden Ausführungsformen, wobei
- eine metallisierte Temporärbondschicht am Produktsubstrats und/oder am Trägersubstrat herstellbar ist,
- das Produktsubstrat mit dem Trägersubstrat an der metallisierten Temporärbondschicht bondbar ist.

Im weiteren Verlauf wird die metallisierte Temporärbondschicht auch Metallisierung genannt.

Die metallisierte Temporärbondschicht kann direkt auf dem Trägersubstrat und/oder direkt auf dem Produktsubstrat hergestellt werden. Alternativ kann zwischen der metallisierten Temporärbondschicht und dem Produktsubstrat eine Schutzschicht angeordnet sein.

Die Schutzschicht weist vorzugsweise einen hohen Reflexionsgrad auf, um das Produktsubstrat vor der Debondstrahlung zu schützen.

Erfindungsgemäß besteht die Temporärbondschicht somit aus einem Metall oder aus einer Metalllegierung.

In einer bevorzugten Ausführungsform ist vorgesehen, dass auf die Substratoberfläche des Produktsubstrats vor der Metallisierung eine Schutzschicht aufgebracht wird.

In einer anderen bevorzugten Ausführungsform ist vorgesehen, dass die Temporärbondschicht vollflächig hergestellt wird, insbesondere auf einer Schutzschicht auf dem Produktsubstrat.

In einer anderen bevorzugten Ausführungsform ist vorgesehen, dass die Temporärbondschicht stellenweise hergestellt wird, weiter bevorzugt an Erhebungen des Trägersubstrats.

In einer anderen bevorzugten Ausführungsform ist vorgesehen, dass eine Schutzschicht auf das Produktsubstrat aufgebracht wird bevor die Herstellung der metallisierten Temporärbondschicht am Produktsubstrats und/oder am Trägersubstrat erfolgt.

In einer anderen bevorzugten Ausführungsform ist vorgesehen, dass das Bonden thermisch erfolgt.

In einer weiteren denkbaren Ausführungsform wird auf dem Trägersubstrat eine Schicht aufgebracht, in der durch Strukturierung Kavitäten erzeugt werden.

Denkbar wäre beispielsweise die Aufbringung eines Polymers, das leicht durch Photolithographie oder Imprintlithographie strukturiert werden kann.

Denkbar wäre auch die Verwendung eines Sol-Gels, um eine einfach zu prägende oder strukturierende aber auch sehr stark aushärtende Verbindung wie SiO2 zu erzeugen.

Die Kavitäten könnten in einer solchen Schicht besonders einfach hergestellt werden. Insbesondere könnte ein solcher Träger von der aufgebrachten Schicht gereinigt und sehr einfach einer erneuten Verwendung zugeführt werden. Das in den Kavitäten abgeschiedene Metall würde durch eine solche Reinigung auf einfachste Art mitentfernt werden.

Die Kavitäten können beliebig geformt und beliebig angeordnet sein. Vorzugsweise besitzen die Kavitäten allerdings eine möglichst einfache geometrische Form und sind regelmäßig angeordnet.

Besonders bevorzugte Formen für den Umfang der Kavitätenwandung sind:
- Rechteckig, insbesondere quadratisch
- Rund
- Elliptisch
- Dreieckig

Insbesondere die dreieckige Form lässt sich in (111) orientierten Siliziumwafern durch Ätzen sehr leicht herstellen.

Die Kavitäten werden vorzugsweise entlang eines zweidimensionalen, rechteckigen, insbesondere quadratischen, Gitters angeordnet.

In einer anderen erfindungsgemäßen Ausführungsform können die Kavitäten entlang eines flächenzentrierten, zweidimensionalen, rechteckigen, insbesondere quadratischen Gitter angeordnet werden.

Vorzugsweise ist das Gesamtvolumen der Kavitäten größer als 10 mal, vorzugsweise größer als 100 mal, noch bevorzugter größer als 1000 mal, am bevorzugtesten größer als 10000 mal, am allerbevorzugtesten größer als 100000 mal dem Volumen der Temporärbondschicht. Diese Werte liegen darin begründet, dass die Temporärbondschicht geschmolzen und verdampft bzw. sublimiert wird, und ein Gasvolumen das Mehrfache des Festkörpervolumens ausmacht.

Die Tiefe der Kavitäten liegt zwischen 1nm und 100µm, vorzugsweise zwischen 10nm und 50µm, noch bevorzugter zwischen 50 nm und 30µm, am bevorzugtesten zwischen 70nm und 20µm, am allerbevorzugtesten zwischen 100nm und 10µm.

Die laterale Dimension der Kavitäten (beispielsweise der Durchmesser einer runden Kavität oder die Seitenlänge einer rechteckigen Kavität) liegt zwischen 10nm und 5mm, vorzugsweise zwischen 50nm und 1mm, noch bevorzugter zwischen 100nm und 500µm, am bevorzugtesten zwischen 500nm und 100µm, am allerbevorzugtesten zwischen 1µm und 50µm.

Nach dem Bonden kann der gefügte Substratstapel bestehend zumindest aus dem Trägersubstrat, aus der metallisierten Temporärbondschicht und aus dem Produktsubstrat weiterprozessiert werden.

Die Erfindung betrifft weiterhin ein Verfahren zum Debonden eines Produktsubstrats von einem Trägersubstrat, wobei das Produktsubstrat und das Trägersubstrat über eine metallisierte Temporärbondschicht verbunden sind und einen Substratstapel bilden, aufweisend mindestens die folgenden Schritte:
- Aufnahme und Befestigung des Substratstapels auf einem Substrathalter,
- Fokussierung einer Debondstrahlung, insbesondere eines Laserstrahls, durch das Trägersubstrat auf die metallisierte Temporärbondschicht und dadurch Aufschmelzung, Verdampfung und/oder Sublimierung der metallisierten Temporärbondschicht,
- Ablösung des Produktsubstrats vom Trägersubstrat.

Die Erfindung betrifft weiterhin eine Vorrichtung zum Debonden eines Produktsubstrats von einem Trägersubstrat, insbesondere mit einem Verfahren nach mindestens einer der vorhergehenden Ausführungsformen, wobei das Produktsubstrat und das Trägersubstrat über eine metallisierte Temporärbondschicht verbunden sind und einen Substratstapel bilden, wobei die Vorrichtung zumindest aufweist:
- einen Substrathalter zur Aufnahme und Befestigung des Substratstapels,
- eine Strahlungsquelle zur Fokussierung einer Debondstrahlung, insbesondere eines Laserstrahls, durch das Trägersubstrat auf die metallisierte Temporärbondschicht und dadurch Aufschmelzung, Verdampfung und/oder Sublimierung der metallisierten Temporärbondschicht,
- Ablösemittel zur Ablösung des Produktsubstrats vom Trägersubstrat.

Bei den Ablösemitteln kann es sich insbesondere um mechanische Ablösemittel wie z.B. Klingen handeln.

In einer weiteren erfindungsgemäßen Ausführungsform kann es sich bei dem Ablösemittel um einen Fluidstrom handeln, der anstatt der Klinge zwischen die beiden Substrate gepresst wird.

In einer bevorzugteren erfindungsgemäßen Ausführungsform handelt es sich bei dem Ablösemittel um die Substrathalter, auf denen das Produktsubstrat und das Trägersubstrat fixiert sind. In einer ersten erfindungsgemäßen Ausführungsform erfolgt eine einfache, insbesondere normal zu den Substratoberflächen orientierte, Relativbewegung zwischen den beiden Substrathaltern nach dem vollständig durchgeführten, erfindungsgemäßen Debond. In einer zweiten erfindungsgemäßen Ausführungsform wird mindestens einer der beiden Substrathalter um eine Rotationsachse gekippt, sodass die Trennung der beiden Substrate an der Peripherie beginnt. In einer dritten erfindungsgemäßen Ausführungsform ist mindestens einer der Substrathalter so konzipiert, dass er nicht nur gekippt, sondern verbogen werden kann. In diesem Fall handelt es sich bei dem Substrathalter vorzugsweise um eine biegbare Platte. Eines der beiden Substrate, vorzugsweise das Trägersubstrat, wird dann während es auf dem biegbaren Substrathalter fixiert wird, von der Peripherie beginnend, kontinuierlich abgezogen. Die Steifigkeit des biegbaren Substrathalters erlaubt dabei eine sehr exakte Kontrolle des Abhebeprozesses.

In einer weiteren, weniger bevorzugten erfindungsgemäßen Ausführungsform handelt es sich bei den Ablösemitteln um Substrathalter, die parallel zu ihren Fixieroberflächen bzw. zu den Substratoberflächen verschiebbar sind. Die beiden Substrate werden dann durch einen Scherprozess voneinander getrennt. Diese Ausführungsform ist im Stand der Technik als "slide-off" Technik bekannt und wird insbesondere bei, mittels eines polymeren Bondingadhäsivs, temporär gebondeten Substraten angewandt. Die Substrate und damit das Bondingadhäsiv werden dabei im Stand der Technik durch eine Heizvorrichtung so lange erwärmt, bis sie durch den Scherprozess voneinander getrennt werden können. Für das erfindungsgemäße Verfahren kann dieser Scherprozess allerdings nur dann zerstörungsfrei funktionieren, wenn garantiert werden kann, dass es so gut wie keine metallische Kontaktpunkte mehr zwischen dem Produktsubstrat und dem Trägersubstrat gibt. Sind nur einige wenige metallische Kontaktpunkte zwischen dem Produktsubstrat und dem Trägersubstrat vorhanden, kann allerdings ein Scherprozess zu einer plastischen Verformung der metallischen Kontaktpunkte führen, die eine zerstörungsfreie Trennung ermöglicht.

Insbesondere können die oben genannten Ablösemittel miteinander kombiniert werden.

Bevorzugt ist vorgesehen, dass die Wärmeleitfähigkeit des Trägersubstrates zwischen 0,1 W/(m*K) und 5000 W/(m*K), weiter vorzugsweise zwischen 1 W/(m*K) und 2500 W/(m*K), noch bevorzugter zwischen 0,5 W/(m*K) und 1000 W/(m*K) liegt.

Bevorzugt ist weiterhin vorgesehen, dass der Substratstapel durch eine Heizung und/oder Kühlung geheizt und/oder gekühlt wird.

Bevorzugt ist weiterhin vorgesehen, dass die Debondstrahlung gepulst auf die metallisierte Temporärbondschicht fokussiert wird.

Bevorzugt ist weiterhin vorgesehen, dass ein Energieeintrag der Debondstrahlung in die metallisierte Temporärbondschicht gemessen wird, und eine Strahlungsleistung der Debondstrahlung geregelt wird.

Bevorzugt ist weiterhin vorgesehen, dass mindestens das Trägersubstrat transparent für die Debondstrahlung ist. Denkbar, wenn auch unwahrscheinlich, ist, dass das Produktsubstrat transparent für die Debondstrahlung ist.

Bevorzugt ist weiterhin vorgesehen, dass die aufgeschmolzene und verdampfte und/oder sublimierte metallisierte Temporärbondschicht vor der Ablösung des Produktsubstrats vom Trägersubstrat in Kavitäten kondensiert und erstarrt und/oder resublimiert.

Insbesondere wird der lokal erhitzte Metalldampf in umliegenden Kavitäten des Trägersubstrats aufgenommen. Der Metalldampf kann dabei in den Kavitäten entweder Resublimieren oder zuerst kondensieren und dann erstarren.

Mit anderen Worten wird die Temporärbondschicht insbesondere mittels Laserstrahlung lokal entfernt.

Besonders bevorzugte Laser und deren Wellenlängen sind
- YAG (1,64 µm)
- Ho:YLF (2,05 µm)
- Ho:YAG (2,09 µm)
- Cr:ZnS

In einem weiteren optionalen Verfahrensschritt kann das Trägersubstrat vermessen werden, ob die, in den Kavitäten abgelagerte Metallisierung entfernt werden muss, oder nicht, um das Trägersubstrat erneut verwenden zu können. Danach steht das Trägersubstrat für das Temporärbonden von weiteren Produktsubstrate zur Verfügung.

### Trägersubstrat

Die Trägersubstrate können jede beliebige Form besitzen, sind aber bevorzugt kreisrund. Der Durchmesser der Substrate ist insbesondere industriell genormt. Für Wafer sind die industreüblichen Durchmesser, 1 Zoll, 2 Zoll, 3 Zoll, 4 Zoll, 5 Zoll, 6 Zoll, 8 Zoll, 12 Zoll und 18 Zoll. Die Trägersubstrate werden in der Größe und Form an die Größe und Form der Produktsubstrate angepasst, damit die verwendete Handhabungstechnologie möglichst einfach ist. Unterschiedliche Substratgrößen bedeuten sog. Bridge-Tools, welche komplizierter aufgebaut sind, als Vorrichtungen und Tools für eine Substratgröße.

Die Erfindung kann aber grundsätzlich jedes Substrat, unabhängig von dessen Durchmesser handhaben. Das Trägersubstrat für die erfindungsgemäße temporäre Bond- und Debondverfahren kann als Wafer ausgeführt sein. Vorzugsweise handelt es sich bei dem Trägersubstrat um ein Glassubtrat.

Erfindungsgemäß ist es denkbar, nicht-kreisrunde Substrate, Paneele mit dem beschriebenen Temporärbondverfahren zu fixieren, zu prozessieren und vom Trägersubstrat zu lösen.

Das Material des Trägersubstrates kann ein Halbleiterwerkstoff, insbesondere Silizium sein. Bevorzugt können günstige, polykristalline Siliziumwafer als Trägersubstrate verwendet werden. In einer besonders bevorzugten erfindungsgemäßen Ausführungsform ist das Trägersubstrates aus technischem Glas hergestellt.

Das Trägersubstrat weist bevorzugt mindestens eines der folgenden Merkmale auf:
- Partikelfreiheit und/oder
- CMOS-Kompatibilität und/oder
- mechanische Steifigkeit und/oder
- eine Wärmeleitfähigkeit, angepasst an das Produktsubstrat, oder höher, und/oder
- Wärmebeständigkeit über der höchsten Prozessierungstemperatur, und/oder
- Warmfestigkeit über der höchsten Prozessierungstemperatur, und/oder
- minimale, vorzugsweise keine, Ausgasung, auch als niedriger Dampfdruck beschreibbar, daraus folgend Hochvakuumtauglichkeit und/oder
- eine ans Produktsubstrat angepasste thermische Dehnung und/oder
- Transparenz für die Debond-Strahlung.

Die Transparenz soll durch den Transmissionsgrad beschrieben werden, der das Verhältnis aus transmittierter und eingestrahlter Strahlung angibt. Der Transmissionsgrad ist allerdings von der Dicke des durchstrahlten Körpers abhängig und damit keine rein materialspezifische Eigenschaft. Die Werte des Transmissionsgrades werden daher auf eine Einheitslänge von 1 cm bezogen angegeben. Das Material besitzt in Bezug auf die gewählte Dicke von 1 cm und für die jeweils gewählte Wellenlänge insbesondere einen Transmissionsgrad größer 70%, vorzugsweise größer 80%, noch bevorzugter größer 90%, am bevorzugtesten größer als 95%, am allerbevorzugtesten größer 99%. Besonders bevorzugt wird die Transparenz auf die Wellenlänge der Debond-Strahlung bezogen.

Für die Funktionalität des Trägersubstrats ist dessen Wärmeleitfähigkeit ebenfalls von Bedeutung, denn die Wirkung der Debond-Strahlung als lokale Erwärmung soll rasch abgeleitet werden. Die Wärmeleitfähigkeit des Trägersubstrates liegt bevorzugt zwischen 0.1 W/(m*K) und 5000 W/(m*K), weiter vorzugsweise zwischen 1 W/(m*K) und 2500 W/(m*K), noch bevorzugter zwischen 0,5 W/(m*K) und 1000 W/(m*K).

Im Rahmen der vorliegenden Erfindung ist das Trägersubstrat strukturiert.

Das Trägersubstrat beinhaltet Erhebungen, welche sich mit dem Produktsubstrat über den metallischen Kontakt stabil verbinden und Vertiefungen, welche als Kanäle oder Kavitäten zwischen den Erhebungen liegen. Als Kennzahl für die Beschaffenheit des Trägersubstrats kann der Traganteil, also das Verhältnis der ermittelten Fläche der Erhebungen zur Gesamtfläche des Trägersubstrats bestimmt werden. Der Traganteil des Trägersubstrats beträgt vorzugsweise weniger als 80%, weiter bevorzugt weniger als 75%, besonders bevorzugt weniger als 50%, ganz besonders bevorzugt weniger als 25%, im Idealfall weniger als 10%. Jedoch kann das Produktsubstrat so fest mit dem Trägersubstrat verbunden werden, dass der Substratstapel als monolithischer Körper weiterprozessiert werden kann und es nicht zu ungewollten Ablösungen kommt.

Der Gedanke bei der Anordnung der Kavitäten und der Erhebungen liegt darin, ein effizientes Halten und ein schnelles und effizientes Ablösen des Produktsubstrates vom Trägersubstrat zu ermöglichen Dazu wird das Trägersubstrat, bzw. die Erhebungen des Trägersubstrats so strukturiert, dass nur ein definiertes Muster von metallischen Verbindungspunkten zum Produktsubstrat besteht und nicht eine flächige Metallisierung.

Es ist alternativ denkbar, in einer anderen Ausführungsform des Trägersubstrats einen vollflächigen temporären Metallbond zum Produktsubstrat herzustellen.

Es ist weiterhin in einer beispielhaften Ausführungsform des Trägersubstrats bevorzugt denkbar, dass insbesondere nah zum. Trägersubstratrand an einem vollumfänglich geschlossenen Ring der temporäre Metallbond zum Produktsubstrat hergestellt wird und weitere Erhebungen des Trägersubstrates (bevorzugt gleichmäßig auf der Fläche innerhalb des metallisierten Ringes) das Produktsubstrat punktförmig und/oder kleinflächig ohne metallischen Kontakt stützen.

Es ist möglich, dass nicht alle Erhebungen in metallischen Kontakt mit dem Produktsubstrat stehen, sondern bevorzugt lediglich definierte, am Umfangsrand des Substratstapels verteilte Punkte.

Erfindungsgemäß Vorteilhafter ist es daher, wenn die Oberflächen der metallisierten Bereiche koplanar zu den Oberflächen der nicht metallisierten Bereiche der Erhebungen sind. Das kann erfindungsgemäß einfach dadurch bewerkstelligt werden, dass die Metallisierung selbst in kleine Vertiefungen erzeugt wird. Denkbar wäre beispielsweise, dass eine vollumfängliche, ringförmige Nut an der Peripherie des Trägerwafers erzeugt wird. Erfindungsgemäß wird dann ausschließlich in dieser Nut eine Metallisierung erzeugt, während die Erhöhungen innerhalb der Nut, die das Produktsubstrat stabilisieren und stützen sollen, frei von einer Metallisierung sind. Auf die unterschiedlichen Prozessschritte, um ausschließlich die Nut zu metallisieren, während die zentrumsnahen Bereiche metallisiert bleiben wird hier nicht näher eingegangen. Der Fachmann auf dem Gebiet weiß wie man den inneren Teil des Trägersubstrats maskieren und schützen kann.

Durch diesen Aufbau des Trägersubstrats ist es möglich, dass bei der Trennung verdampfendes oder verflüssigendes Metall neben den Erhebungen, insbesondere punktförmigen Erhebungen, in den kalten Kavitäten kondensiert und erstarrt und/oder resublimiert. Damit wird Material gezielt und lokal aus der Temporärbondschicht abgeführt. Somit wird bei dem finalen Phasenübergang der Temporärbondschicht in die feste Phase das Metall nicht erneut festlöten und/oder bonden. Als Wirkung kann dementsprechend der Substratstapel nach gezieltem Aufbrechen aller Bondpunkte leicht getrennt werden.

In einer besonders bevorzugten Ausführungsform des Trägersubstrats besitzen die Erhebungen eine Ebenheit, ausgedrückt als total thickness variation (TTV) kleiner als 100 µm, vorzugsweise kleiner als 10 µm, mit größerem Vorzug kleiner als 1 µm, mit größtem Vorzug kleiner als 100 nm, mit allergrößtem Vorzug kleiner als 10 nm, am bevorzugtesten kleiner als 1 nm. Somit kann das Produktsubstrat besonders eben festgehalten werden.

In einer anderen besonders bevorzugten Ausführungsform des Trägersubstrats sind die Erhebungen als bombierte Einzelflächen ausgeführt, sodass ein bevorzugt punktförmiger Kontakt zwischen dem Trägersubstrat und dem Produktsubstrat entsteht und die Metallisierung in einer Form der Selbstausrichtung bevorzugt die Fläche des temporär verbondeten metallischen Kontaktes mit der Kapillarwirkung reduziert.

Es ist weiterhin denkbar, dass das Trägersubstrat vor der Metallisierung teils metallabweisend behandelt wird, sodass insbesondere durch eine Tauchmetallisierung lediglich die erwünschten Erhebungen benetzt werden.

Es ist vorteilhaft denkbar, dass die Einzelflächen der Erhebungen des Trägersubstrats an den Durchmesser des Debond-Strahls angepasst werden. Als konkretes Zahlenbeispiel kann insbesondere bei einer Laserspotgröße von 30 Mikrometer Durchmesser die Erhebung als eine Fläche mit einem Durchmesser von 30 Mikrometer, bevorzugt 28 Mikrometer, besonders bevorzugt 25 Mikrometer ausgeführt sein.

Verallgemeinert heißt es, dass die Erhebungen weniger als 95% der Debondspotgröße, bevorzugt weniger als 90% der Debondspotgröße, besonders bevorzugt weniger als 85% der Debondspotgröße betragen, um eine schnelle, effiziente, hochenergetische Energieeinkopplung bei der Trennung des Substratstapels zu erreichen.

### Verfahren zum Temporärbonden

Es ist bevorzugt denkbar, dass auf das Produktsubstrat vor dem Temporärbonden auf die zu bondende Substratoberfläche eine Schutzschicht aufgebracht werden kann. Die Erstellung der Schutzschicht des Produktsubstrats kann örtlich und/oder zeitlich von den weiteren Verfahrensschritten des Temporärbondes getrennt durchgeführt werden.

In einer bevorzugten Ausführungsform kann die Schutzschicht als eine Diffusionsbarriere der Metallisierung das Produktsubstrat vor der Temporärbondschicht schützen.

In einer weiteren bevorzugten Ausführungsform kann die Schutzschicht eine strukturierte Substratoberfläche des Produktsubstrates insbesondere durch entfernbares Auffüllen und Abdecken der Kavitäten schützen.

In einer weiteren bevorzugten Ausführungsform der Schutzschicht kann sie als Haftvermittler zwischen dem Produktsubstrat und der Metallisierung dienen.

Es wird eine Metallisierung auf die vorbereitete zu bondende Substratoberfläche aufgebracht. In einer alternativen Ausführungsform des Verfahrens wird die Metallisierung auf die Schutzschicht aufgebracht.

In einer alternativen Ausführungsform des erfindungsgemäßen Verfahrens kann die Metallisierung auf das Trägersubstrat aufgebracht werden.

Es können vorteilhaft niedrigschmelzende Metalle oder Legierungen, insbesondere eutektische Legierungen verwendet werden. Besonders vorteilhaft dringt die aufgebrachte Metallisierung des Produktsubstrats nicht ins Gefüge des Produktsubstrates hinein, sodass das Verfahren keine Dotierung und keine Kontaminierung verursacht.

In einer weiteren bevorzugten Ausführungsform kann die Metallisierung aus einem Metall oder einer Legierung einer, in der weiteren Prozessierung verwendeten permanenten Bondschicht bestehen, sodass eine Diffusion der Metallisierung keine schädliche Wirkung auf das Produktsubstrat ausübt.

Es können insbesondere CMOS-kompatible Metalle und/oder Legierungen verwendet werden.

Insbesondere können folgende Verbindungen oder Elemente in der Metallisierung enthalten sein:
- Metalle, insbesondere Cu, Ag, Au, Al, Fe, Ni, Co, Pt, W, Cr, Pb, Ti, Ta, Zn, Sn.
- Verbindungen, insbesondere Nitridverbindungen, insbesondere AlN, GaN, TiN, TaN

Bevorzugt werden Metalle und/oder Legierungen für die Temporärbondschicht aus Metall ausgewählt, welche eine für die Prozessierung ausreichende Festigkeit bei ausreichend niedriger Schmelztemperatur aufweisen.

Es ist insbesondere vorteilhaft als eine Legierung eine eutektische Legierung als Metallisierung zu verwenden.

Bei der Verwendung einer Legierung mit einer eutektischen Konzentration kann diese bei der Herstellung der Metallisierung erzeugt oder während des Bonden eingestellt werden. Eine eutektische Legierung zeichnet sich durch den niedrigsten aller Schmelzpunkte aller möglichen Legierungen, die durch Variation der Legierungskomponenten hergestellt werden können, aus. Durch das Überschreiten der eutektischen Temperatur, der Temperatur, bei der sich die flüssige Phase mit den festen Phasen des Eutektikums im Gleichgewicht befindet, schmilzt das Eutektikum vollständig auf. Die erzeugte flüssige Phase der eutektischen Konzentration benetzt die Oberfläche der noch nicht verflüssigten Bereiche der beiden miteinander zu verbondenen Substrate. Beim Erstarrungsvorgang erstarrt die flüssige Phase zum Eutektikum und bildet die Verbindungsschicht als Temporärbondschicht zwischen den beiden Substraten.

Zur Herstellung der Metallisierung ist es insbesondere erfindungsgemäß denkbar, eine Legierungskomponente auf das Produktsubstrat und eine Legierungskomponente auf das Trägersubstrat aufzubringen.

Es ist erfindungsgemäß insbesondere denkbar, dass die Metallisierung auf dem Produktsubstrat als eine Schichtfolge unterschiedlicher Metalle und/oder Legierungen als Legierungskomponente und/oder als die komplette Metallisierung aufgetragen wird.

Es ist erfindungsgemäß in einer alternativen Ausführungsform des Verfahrens insbesondere möglich, dass die Metallisierung auf das Trägersubstrat als eine Schichtfolge der Legierungskomponenten und/oder die komplette Metallisierung aufgetragen wird.

Es ist insbesondere zu beachten, dass die erzeugten Schichten, also eine Schutzschicht und zumindest eine Metallisierung bei Raumtemperatur und normaler Atmosphäre keine Alterungs- und/oder Korrosionserscheinungen aufweisen sollen, um den dritten Verfahrensschritt optimal durchführen zu können. Alternativ kann das metallisierte Substrat in einer inerten Atmosphäre und/oder im Vakuum geschützt gelagert werden.

Als Auftragungstechnologien für die Metallisierung eignen sich insbesondere elektrochemische Abscheideverfahren wie eine Galvanisierung, Aufdampfen, Aufsputtern, chemische Dampfabscheidung (CVD).

In einem weiteren Verfahrensschritt wird das Produktsubstrat mit dem Trägersubstrat insbesondere thermisch in einem Temporärbondverfahren für metallische Temporärbonds miteinander verbunden. Es ist erfindungsgemäß insbesondere denkbar, den Temporärbond in einer evakuierten Bondkammer durchzuführen.

In einer bevorzugten Ausführungsform kann die Temperatur des Temporärbondverfahrens weit unter der weiteren Prozessierungstemperatur des Produktsubstrates liegen, um insbesondere nicht erwünschte Diffusionsvorgänge zu verlangsamen oder bevorzugt zu unterbinden.

Es ist erfindungsgemäß insbesondere vorteilhaft, dass die Verwendung von Metall-Metall-Bonds die Partikelbelastung des Substrats insbesondere mit Partikeln aus organischen Rückständen reduziert.

Es ist erfindungsgemäß insbesondere vorteilhaft, dass die aufschmelzende metallische Temporärbondschicht Partikel in sich als Einschlüsse aufnimmt, sodass eine bessere Bondqualität erreicht werden kann.

Es ist insbesondere erfindungsgemäß denkbar, dass die Metall-Metall Temporärbonds als transient-Liquid-Phase (TLP) Bonds durchgeführt werden.

Es ist insbesondere erfindungsgemäß vorteilhaft denkbar, dass die Metallisierung zum Temporärbonden auf das Trägersubstrat aufgebracht wird und der Temporärbond zwischen der metallisierten Substratoberfläche des Trägersubstrates und der Schutzschicht des Produktsubstrates entsteht.

Es ist insbesondere erfindungsgemäß ebenfalls denkbar, dass die Metallisierung zum Temporärbonden auf das Trägersubstrat aufgebracht wird und der Temporärbond zwischen der metallisierten Substratoberfläche des Trägersubstrats und der zu bondenden Substratoberfläche des Produktsubstrates entsteht.

Es ist insbesondere erfindungsgemäß denkbar, dass die verwendeten Metallbonds in einem Fusionsbondverfahren ähnlich einem Hybridbondverfahren mit anschließender Wärmebehandlung für die Herstellung des Temporärbondes miteinander verbunden werden. Fusionsbonds entstehen vor allem an den Oberflächen von nichtmetallischnichtorganischen Materialien. Dabei können die Oberflächenanteile des Produkt- und des Trägersubstrats insbesondere in einer engen Fügung zueinander Wasserstoff-Brückenbindungen herstellen, sodass die Substrate insbesondere geschützt und für die Weiterprozessierung wie eine Wärmebehandlung transportierbar werden. Der Fusionsbond selbst dient nur der Vorfixierung und sorgt dafür, dass die metallischen Bereiche, die miteinander verbunden werden sollen, in Position gehalten werden. Diese Vorfixierung wird im Stand der Technik als Prebond bezeichnet.

Prebondverfahren beschreiben Prozesse, bei denen zwei Substrate alleine durch van-der-Waals Kräfte miteinander gebondet werden. Dieser Bondvorgang findet vor allem zwischen Silizium-Substraten und/oder Siliziumoxidsubstraten statt. Der so hergestellte Bond wird als Prebond bezeichnet, da es sich um eine Vorstufe einer weiteren Verbindung handelt. In der Halbleiterindustrie ist es sehr oft erwünscht, ein durch einen Prebond erzeugte (temporäre) Verbindung wieder zu lösen, wenn man nach dem Prebond feststellt, dass die beiden Substrate nicht optimal oder sogar falsch zueinander ausgerichtet wurden. Die beiden durch einen Prebond miteinander verbundenen Substrate können meistens ohne Beschädigung wieder voneinander getrennt werden.

Mit anderen Worten wird ein Fusionsbond als Prebond auf den nichtmetallischen Oberflächenanteilen zwischen dem Produktsubstrat und dem Trägersubstrat für die Vorfixierung des Substratstapels erstellt.

Danach können flächige metallisierte Oberflächenteile des Trägersubstrats mit dem Produktsubstrat in einer Wärmebehandlung miteinander temporär metallisch gebondet werden.

Ein erfindungsgemäßes Verfahren zum Fusionsbonden von einem Produktsubstrat mit einem Trägersubstrat weist in einer beispielhaften Ausführungsform folgende Verfahrensschritte auf:

In einem ersten Verfahrensschritt des beispielhaften Verfahrens werden die zu fügenden Oberflächen des Produktsubstrats und/oder des Trägersubstrats vorbereitet und strukturiert.

In einem zweiten Verfahrensschritt werden die zu fügenden Oberflächen des Produktsubstrats und des Trägersubstrats insbesondere in einer Plasmakammer mittels Plasmabehandlung aktiviert.

In einem dritten Verfahrensschritt werden die zu fügenden Oberflächen insbesondere mit DI-Wasser gespült. Damit werden generierte Partikel ebenfalls entfernt.

In einem vierten Verfahrensschritt werden das Produktsubstrat und das Trägersubstrat zumindest rein mechanisch zueinander ausgerichtet.

In einem fünften Verfahrensschritt werden das Produktsubstrat und das Trägersubstrat miteinander zumindest in einem Punkt kontaktiert und somit wird eine Bondwelle gestartet. Der Durchlauf der Bondwelle bondet den Substratstapel in einem Prebond zueinander.

In einem sechsten Verfahrensschritt wird der Substratstapel bestehend aus einem Produktsubstrat und einem Trägersubstrat einer Wärmebehandlung zur Herstellung eines temporären Metall-Metall-Bondes unterzogen. Dabei sind die Bondkräfte (van-der-Waals'sche Kräfte) des Prebondes geringer, als die Haltekraft der metallischen Temporärbondschicht.

Entgegen der üblichen Technologie eines Hybridbonds wird in diesem Temporärbondverfahren die permanente flächige Fügung der nichtmetallischen Substratoberflächenanteile nicht erfolgen.

Der Grundgedanke der hier aufgeführten Temporärbondverfahren ist, dass ein Substratstapel hergestellt wird, welcher zumindest aus einem Trägersubstrat, aus einer metallischen Temporärbondschicht und aus einem Produktsubstrat besteht.

Mit anderen Worten wird mit den offenbarten Temporärbondverfahren ein Substratstapel hergestellt, wobei die Temporärbondschicht eine Metall- oder eine Metalllegierungsschicht ist und wobei die Temporärbondschicht im erfindungsgemäßen Temporärdebondverfahren insbesondere rückstandsfrei und partikelfrei vom Produktsubstrat entfernbar ist. Ein weiterer Vorteil ist, dass die Substrate des Substratstapels größere Bearbeitungskräfte aufnehmen können, als mit einer polymeren Zwischenschicht. Durch das später beschriebene Trennverfahren kann der Substratstapel kraft- und/oder verzerrungs- und/oder spannungsarm getrennt werden. Es ist weiterhin vorteilhaft, dass zur Trennung keine Lösungsmittel und/oder Chemikalien, mit anderen Worten keine Nasschemie verwendet werden müssen.

Das so geschützte und gestützte Produktsubstrat als Teil eines Substratstapels kann also einfacher, materialschonender und kostengünstiger weiterverarbeitet werden, als ein mit adhäsivem Polymer befestigter Substratstapel.

### Verfahren zum Debonden

Das Verfahren zur Trennung des Trägersubstrats vom Produktsubstrat hat in einer beispielhaften Ausführungsform folgende Schritte, insbesondere folgenden Ablauf:
In einem ersten Verfahrensschritt wird der temporär gebondete Substratstapel auf einem Substrathalter aufgenommen und befestigt.

Die Substrathalter verfügen über Fixierungen. Die Fixierungen dienen dem Festhalten der Substrate. Bei den Fixierungen kann es sich um
- 1.: Mechanische Fixierungen, insbesondere
- 1.1.: Klemmen,
- 2.: Vakuumfixierungen, insbesondere mit
- 2.1.: einzeln ansteuerbaren Vakuumbahnen,
- 2.2.: miteinander verbundenen Vakuumbahnen,
- 3.: Elektrische Fixierungen, insbesondere
- 3.1.: Elektrostatische Fixierungen,
- 4.: Magnetische Fixierungen,
- 5.: Adhäsive Fixierungen, insbesondere Gel-Pak Fixierungen, und/oder
- 6.: Fixierungen mit adhäsiven, insbesondere ansteuerbaren Oberflächen, handeln.

Die Fixierungen sind insbesondere elektronisch ansteuerbar.

Die Vakuumfixierung ist die bevorzugte Fixierungsart. Die Vakuumfixierung besteht vorzugsweise aus mehreren Vakuumbahnen, die an der Oberfläche des Substrathalters austreten. Die Vakuumbahnen sind vorzugsweise einzeln ansteuerbar. In einer technisch eher realisierbaren Anwendung sind einige Vakuumbahnen zu Vakuumbahnsegmenten vereint, die einzeln ansteuerbar, daher evakuiert oder geflutet werden können. Jedes Vakuumsegment ist allerdings unabhängig von den anderen Vakuumsegmenten. Damit erhält man die Möglichkeit des Aufbaus einzeln ansteuerbarer Vakuumsegmente. Die Vakuumsegmente sind vorzugsweise ringförmig. Dadurch wird eine gezielte, radialsymmetrische, insbesondere von innen nach außen durchgeführte Fixierung und/oder Loslösung eines Substrats, insbesondere eines Produktsubstrats vom Substrathalter ermöglicht.

In einem zweiten Verfahrensschritt wird zumindest ein gebündelter Energiestrahl mindestens einer Wellenlänge, insbesondere ein Laserstrahl durch das Trägersubstrat auf die metallische Temporärbondschicht fokussiert und damit die Temporärbondschicht aufgeschmolzen und verdampft oder sublimiert.

In einer alternativen Ausführungsform können mehrere Strahlen zum Energieeintrag in die Temporärbondschicht parallel eingeleitet werden.

In einer bevorzugten Ausführungsform kann der Substratstapel auf dem Substrathalter auf eine bestimmte Temperatur gebracht, gekühlt oder geheizt werden. Damit kann insbesondere ein größerer thermischer Gradient zur Rissbildung erreicht werden. Weiterhin ist ein Vorteil einer Temperierung, insbesondere Kühlung, dass die gasförmigen Produkte der Debondstrahlung schneller kondensieren und/oder resublimieren können.

Der Energieeintrag für die Phasenumwandlung der metallischen Temporärbondschicht wird bevorzugt gepulst in die Temporärbondschicht eingeleitet. Damit wird die unerwünschte globale Erwärmung des Substratstapels reduziert.

Der Energieeintrag erfolgt insbesondere durch das, für die Debondstrahlung zumindest überwiegend transparente Trägersubstrat direkt in die Temporärbondschicht. Damit können beliebig dotierte und/oder beliebig für die Debondstrahlung undurchsichtig metallisierte Produktsubstrate vom Trägersubstrat getrennt werden.

Es ist erfindungsgemäß insbesondere vorteilhaft, dass während des Energieeintrags der Debondstrahlung in die Temporärbondschicht insbesondere die reflektierte Strahlung insbesondere kontinuierlich gemessen wird. Damit kann die Strahlungsleistung der Debondvorrichtung insbesondere in Echtzeit geregelt werden. Weiterhin liefert die reflektierte Strahlungsmenge Rückschlüsse über der erfolgten lokalen Trennung. Der Anteil des reflektierten Strahlungsanteils ändert sich während des Debondvorgangs.

In einem dritten Verfahrensschritt wird der lokal erhitzte Metalldampf insbesondere in den tieferen umliegenden Kavitäten des Trägersubstrats resublimiert bzw. kondensiert und erstarrt.

In einer alternativen Ausführungsform kann der lokal erhitzte Metalldampf in den tieferen umliegenden Kavitäten des Trägersubstrats zuerst kondensieren und dann erstarren.

Mit anderen Worten im dritten Verfahrensschritt wird die Temporärbondschicht mittels gepulster Laserstrahlung lokal entfernt.

Dabei wird das Trägersubstrat so ausgelegt, dass die Metalldämpfe insbesondere strömungsoptimiert in die Kavitäten geleitet werden und die Resublimierung oder die Kondensation und die Erstarrung somit ein gesteuerter Vorgang und kein selbst überlassener physikalischer Effekt ist.

Dies kann insbesondere mit den folgenden aktiv einstellbaren Parametern beeinflusst werden:
- mit der Auslegung des Trägersubstrats (Traganteil, Form und Lage der Kavitäten, Druck in den Kavitäten des Substratstapels) und/oder
- mit dem Energieeintrag der Debond-Strahlung (Zeit, Wellenlänge, Energiedichte, Fläche des Laserspots als Parameter) und/oder
- mit der globalen Temperatur des Substratstapels und/oder mit dem Temperaturgradient zwischen des mittels Debond--Strahlung aufgeheizten Spots auf der Erhebung auf dem Trägersubstrat und dem Boden der Kavitäten).

Für eine gezielte Beeinflussung des Debondvorgangs ist es erfindungsgemäß insbesondere denkbar, dass die eine Seite des Substratstapels gekühlt und die andere Seite des Substratstapels beheizt wird. Insbesondere kann das Produktsubstrat beheizt und gleichzeitig das Trägersubstrat insbesondere mit Trockeneisspülung oder Flüssigstickstoffspülung gekühlt werden, um die gezielte Kondensation und/oder Resublimierung lokal zu beeinflussen.

Die entfernte Metallisierung wird insbesondere in die Kavitäten des Trägersubstrats eingelagert.

Insbesondere kann die, auf das Produktsubstrat aufgebrachte Schutzschicht einen Teil der resublimierten oder kondensierten und erstarrten Metallisierung aufnehmen.

In einem vierten Verfahrensschritt werden das Trägersubstrat und das Produktsubstrat voneinander entsprechend getrennt.

In einem fünften optionalen Verfahrensschritt kann das Trägersubstrat vermessen werden, ob die abgelagerte Metallisierung entfernt werden soll, oder nicht. Danach steht das Trägersubstrat für das Temporärbonden für weitere Produktsubstrate zur Verfügung.

Die Verfahren können automatisiert in einer Vorrichtung ablaufen. Dazu können die Verfahrensschritte als Rezepte gespeichert und ausgeführt werden.

Rezepte sind optimierte Wertesammlungen von Parametern, die im funktionalen oder verfahrenstechnischen Zusammenhang stehen. Die Nutzung von Rezepten erlaubt es, eine Reproduzierbarkeit von Produktionsabläufen zu gewährleisten.

### Vorrichtung zum temporären Metallbonden

Die beim erfindungsgemäßen Temporärbonden verwendete Vorrichtung ist ein Bonder für metallische Temporärbonds.

Die funktionsrelevanten Teile des Temporärbonders können insbesondere in Modulbauweise folgende Module enthalten:
- Bondmodul,
- Ausrichtungsmodul,
- Reinigungsmodul,
- Aktivierungsmodul,
- Metallisierungsmodul,
- Beschichtungsmodul,
- Bewegungsapparat, und/oder
- Versorgungsmodul für insbesondere Druckluft, Vakuum.

Im Bondmodul wird das erfindungsgemäßen Temporärbondverfahren durchgeführt. Dazu werden die Substrate bevorzugt auf Substrathaltern festgehalten und thermisch gebondet. Es kann also eine Funktionsintegration eines thermischen Bondchucks mit einem Substrathalter erfolgen.

Es ist erfindungsmäßig insbesondere denkbar, dass eine Permanentbondvorrichtung den erfindungsgemäßen Temporärbond durchführt.

Für Temporärbonds ähnlich einem Hybridbond kann das Ausrichtungsmodul einen Prebond erstellen und das Bondmodul wie ein temperaturgeregelter Ofen insbesondere in einem Batch-Prozess mehrere Substratstapel gleichzeitig metallisch miteinander verbinden.

Die Ausrichtungsgenauigkeit zwischen dem Produktsubstrat und dem Trägersubstrat kann mit mechanischer Ausrichtung oder insbesondere mit optischer Ausrichtung des Substratrandes erfolgen. In einigen Fällen ist eine Ausrichtung an Hand von Ausrichtungsmarken an den Substraten und/oder Substrathaltern ebenfalls möglich.

Die Ausrichtungsgenauigkeit zwischen dem Produktsubstrat und dem Trägersubstrat beträgt weniger als +/-150 Mikrometer, bevorzugt weniger als +/- 100 Mikrometer, besonders bevorzugt weniger als +/- 50 Mikrometer, ganz besonders bevorzugt weniger als +/-25 Mikrometer, im optimalen Fall weniger als +/- 10 Mikrometer, im idealen Fall weniger als +/- 1 Mikrometer, bezogen auf die Mittelpunkte der Substrate und/oder die Peripherie und/oder vorhandenen Ausrichtungsmarkierungen.

Es ist erfindungsgemäß insbesondere vorteilhaft, dass Bondvorrichtungen, welche permanente Metallbonds zwischen Substraten herstellen können, für metallische Permanentbonds ebenfalls eingesetzt werden können.

Es werden in einem Temporärbonder für metallische Temporärbonds insbesondere die Erhebungen des Trägersubstrats mit den korrespondierenden Flächen des Produktsubstrates metallisch verbondet und somit verbunden. Mit anderen Worten wird im Temporärbonder ein Substratstapel hergestellt, welcher mit der metallischen Temporärbondschicht die Erhebungen des Trägersubstrats mit dem Produktsubstrat für die Weiterprozessierung des Produktsubstrates verbindet.

Die Bondkraft, welche für das Bonden des Produktsubstrats zum Trägersubstrat benötigt wird, ist davon abhängig, welche Substratgröße, und/oder welche Metallisierung und/oder welche metallisierte Bondfläche technologisch benötigt werden.

Es können Bondkräfte zwischen 10 N und 100 kN, bevorzugt zwischen 10 kN und 90 kN, besonders bevorzugt zwischen 30 kN und 80 kN verwendet werden. Die Bondkraft kann insbesondere für eine gute Schmiegung der Substrate zueinander verwendet werden. Eine höhere Bondkraft hat sich als vorteilhaft erwiesen für Metallbonds, wobei die Edukte der Metallisierung eine dünne natürliche Oxidschicht entwickeln können, welche mit der Bondkraft aufgebrochen werden kann.

### Vorrichtung zum Debonden von metallischen Temporärbonds

Die beim erfindungsgemäßen Debonden verwendete Vorrichtung ist ein Debonder für metallische Temporärbonds.

Der Debonder für metallische Temporärbonds kann insbesondere in einer Modulbauweise aufgebaut werden. Sollte der Debonder als Einzelvorrichtung ohne Module aufgebaut sein, gelten die Modulbezeichungen als Merkmale für die einzelnen Funktionsgruppen und/oder Komponenten.

Es können insbesondere zumindest folgende Module im Debonder vorhanden sein:
- Debondmodul,
- weitere Module.

Die weiteren Module können folgende Module beinhalten:
- Reinigungsmodul insbesondere für die Entfernung der Schutzschicht,
- Reinigungsmodul für die Entfernung der überschüssigen Metallisierung vom Trägersubstrat,
- Modul für einen Carrier-flip-flop, insbesondere ein -Tape- oder Laminiermodul für die Befestigung des insbesondere gedünnten Produktsubstrats,
- Messmodul für die Metallisierung, und/oder
- separates Lasermodul für das Debondmodul.

Es ist erfindungsgemäß vorteilhaft insbesondere möglich, dass ein separates Lasermodul die Debond-Strahlung erzeugt und lediglich die "kalte" Strahlung ins Debondmodul eingekoppelt wird. Somit können die parasitären Wärmequellen in der Vorrichtung reduziert werden. Es kann das Lasermodul - bei entsprechender Kapselung der optischen Komponenten des Lasermoduls - in den Grauraum eines Reinraumes ausgelagert werden, wobei eine entsprechende Kühlung für die Strahlungsquelle gewährleistet werden kann. Somit wird nicht der genau klimatisierte Reinraum aufgeheizt und somit kann die Abwärme besser aus der Vorrichtung geführt werden.

Die Strahlungsquelle des Debondmoduls erzeugt die Debond-Strahlung, insbesondere eine Laserstrahlung. Es können jedoch alternativ Elektronenstrahlen als Debond-Strahlung verwendet werden.

Es wird die Verwendung unterschiedlicher elektromagnetischer Quellen zur Erzeugung eines Debond-Strahls für elektromagnetische Strahlung offenbart, die für das erfindungsgemäße Lösen verwendet werden können:
- Mikrowellenquelle,
- Infrarotquelle, insbesondere eine mittleres Infrarot (MIR) emittierende Infrarotquelle
- sichtbares Licht emittierende Quelle,
- UV-Quelle, und/oder
- Röntgenquelle.

Insbesondere ist eine Quelle denkbar, die geeignet ist, die erfindungsgemäße Trennung des Trägersubstrats, insbesondere durch Auflösung, am bevorzugtesten durch Sublimierung, der metallischen Verbindungsschicht vom Produktsubstrat durch elektromagnetische Wellen zu bewirken.

Ein weiterer erfindungsgemäßer Aspekt besteht auch darin, dass Metalle eine sehr hohe Absorptionsfähigkeit für Infrarotstrahlung besitzen. Dementsprechend ist die metallische Temporärbondschicht sehr gut dafür geeignet, durch einen Infrarotlaser zerstört zu werden.

Die elektromagnetische Strahlung einer solchen Quelle kann inkohärent oder kohärent sein. Bevorzugt werden Quellen, die kohärente elektromagnetische Strahlung emittieren (Laser). Eine Mikrowellenquelle, die kohärente Mikrowellenstrahlen emittiert, wird als Maser bezeichnet.

Kohärenz beschreibt im weiteren Verlauf der Patentschrift räumliche und/oder zeitliche Kohärenz.

Die Wellenlänge der Debond-Strahlung liegt zwischen 10 nm und 10 mm, bevorzugt zwischen 150 nm und 200 Mikrometer, besonders bevorzugt zwischen 400 nm und 30 Mikrometer, ganz besonders bevorzugt zwischen 1 Mikrometer und 10 Mikrometer.

Es ist erfindungsgemäß insbesondere vorteilhaft, wenn die maximale Absorbanz der metallischen Temporärbondschicht sowie die Wellenlänge der Strahlungsquelle für die Debond-Strahlung aufeinander abgestimmt werden, sodass das Debonden effektiv stattfinden kann. Es ist weiterhin erfindungsgemäß vorteilhaft, wenn die maximale Absorbanz der metallischen Temporärbondschicht und die maximale Transmittanz des Trägersubstrats sowie die Wellenlänge der Debond-Strahlung aufeinander abgestimmt werden. Dazu kann der Fachmann den bekannten Lambert-Beer'schen Zusammenhang verwenden.

Es ist erfindungsgemäß vorgesehen, dass die Debond-Strahlung bei kontinuierlich arbeitender Strahlungsquelle mit einem elektromechanischen Chopper und/oder mit einem Spiegelsystem unterbrochen werden kann und/oder in eine Senke geleitet wird, wenn die Debond-Strahlung nicht verwendet wird aber die Strahlungsquelle weiterhin eingeschaltet ist.

Bei einer schaltbaren Strahlungsquelle wie ein LED-Laser kann die Pulsdauer der Debond-Strahlung elektronisch gesteuert und/oder geregelt werden.

Die Debond-Strahlung wird in der Debondvorrichtung auf die metallisch verbundenen Regionen des Substratstapels gelenkt.

Ein wichtiger physikalischer Parameter der verwendeten elektromagnetischen Strahlung ist die Intensität. Die Intensität wird in Watt angegeben. Die Intensität der elektromagnetischen Strahlung ist insbesondere größer als 0,1 Watt, vorzugsweise größer als 1 Watt, noch bevorzugter größer als 100 Watt, am bevorzugtesten größer als 1000 Watt, am allerbevorzugtesten größer als 10 Kilowatt.

In der Debondvorrichtung können durch optische Elemente die Intensitätsprofile, also der Verlauf der Intensität entlang einer Richtung durch die Strahlform der Debond-Strahlung, beliebig eingestellt werden. Bevorzugte Intensitätsprofile sind:
- Gaussprofil,
- Rechteckprofil,
- Dreiecksprofil, und/oder
- Elliptische Profile, insbesondere Kreisprofile.

Die Leistung des Lasers, gemessen als Lichtleistung, insbesondere Strahlungsleistung, welche kontinuierlich am Substratstapel, insbesondere in der Temporärbondschicht abgegeben werden kann, beträgt insbesondere mindestens 5 W, vorzugsweise mehr als 10 W, noch bevorzugter mehr als 15 W, am bevorzugtesten mehr als 17 W, am allerbevorzugtesten mehr als 30 W.

Der bevorzugte Wellenlängenbereich des Lasers liegt zwischen 100 nm-10000 nm, vorzugsweise zwischen 250 nm- 1100 nm, noch bevorzugter zwischen 270 nm- 430 nm, am bevorzugtesten zwischen 280 nm- 380 nm.

In anderen Ausführungsformen liegt der bevorzugte Wellenlängenbereich des Lasers zwischen 1000 nm - 10000 nm.

Die Wellenlänge des Lasers ist in einer besonders bevorzugten Ausführungsform mittels Frequenzwandler, insbesondere akustooptischen Modulatoren, insbesondere Bragg-Zellen, einstellbar und/oder filterbar.

In einer weiteren bevorzugten Ausführungsform der Vorrichtung beinhaltet der Laserstrahl mindestens eine Wellenlänge aus der Gesamtheit von 1064 nm, 420 nm, 380 nm, 343 nm, 318 nm, 308 nm, 280 nm.

Besonders vorteilhaft ist insbesondere die Verwendung von Laserstrahlen mit mindestens zwei Wellenlängen, um insbesondere photochemische und photothermische Vorgänge kombiniert in der Temporärbondschicht bewirken zu können.

In einer besonders bevorzugten Ausführungsform der Vorrichtung ist die Strahlquelle ein Diodenlaser.

Die Gesamtenergie der Laserstrahlung pro Substrat wird insbesondere zwischen 0,01 mJ und 5000 kJ, bevorzugt zwischen 0,1 mJ und 4000 kJ, besonders bevorzugt zwischen 100 mJ und 2000 kJ eingestellt.

Der Laserstrahl kann im kontinuierlichen Modus oder gepulst betrieben werden.

Die Pulsfrequenz wird insbesondere zwischen 0,1 Hz und 300 MHz, bevorzugt zwischen 100 Hz und 500 kHz, besonders bevorzugt zwischen 10 kHz und 400 kHz, ganz besonders bevorzugt zwischen 100 kHz bis 300 kHz, eingestellt.

Die Anzahl der Pulse pro Substratstapel beträgt in Abhängigkeit der benötigten Gesamtenergie bevorzugt mehr als 1 Mio. Pulse, bevorzugt mehr als 3 Mio. Pulse, besonders bevorzugt mehr als 5 Mio. Pulse, ganz besonders bevorzugt 6 Mio. Pulse.

Die Energie, welche pro Puls Bestrahlung den Substratstapel trifft, wird insbesondere zwischen 0,1 nJ und 1 J, bevorzugt zwischen 1 nJ und 900 µJ, besonders bevorzugt zwischen 10 nJ und 500 µJ eingestellt.

Die Bestrahlungsfläche pro Puls liegt insbesondere zwischen 1 µm2 und 100000 µm2, bevorzugt 10000 µm2 und 50000 µm2, besonders bevorzugt 1000 µm2 und 40000 µm2, ganz besonders bevorzugt zwischen 2500 µm2 und 26000 µm2.

Synonyme für die Bestrahlungsfläche sind als Fleckgröße, Strahlfleck (engl. laser spot size) dem Fachmann bekannt.

Die Bestrahlung eines größeren Bereichs kann entweder vollflächig oder durch einen Scanvorgang erfolgen. Sind die Bereiche mit der Temporärbondschicht ungefähr so groß wie die Bestrahlungsfläche, erfolgt eine einfache, nicht scannende, Bestrahlung. Sind die Bereiche mit der Temporärbondschicht größer als die Bestrahlungsfläche, erfolgt vorzugsweise eine scannende Bestrahlung.

Die Form der Bestrahlungsfläche ist insbesondere kreisförmig, in anderen bevorzugten Ausführungsformen elliptisch, in besonders bevorzugten Ausführungsformen rechteckförmig.

Bevorzugt ist die Debond-Strahlung fokussierbar. Die Länge, innerhalb welcher der Fokuspunkt geändert werden kann, ist insbesondere größer als 0.1 mm, vorzugsweise größer als 1 mm, noch bevorzugter größer als 5 mm, am bevorzugtesten größer als 10 mm, am allerbevorzugtesten größer als 20 mm.

Gemäß einer bevorzugten Weiterbildung der Erfindung ist ein Pulsbetrieb der verwendeten Quelle für die elektromagnetische Debond-Strahlung vorgesehen. Durch eine relativ hohe Intensität und Leistungsdichte kann es zu einer Wärmeübertragung von der Temporärbondschicht auf die Substrate kommen. Um eine derartige Wärmeübertragung weitestgehend zu unterbinden, werden vorzugsweise gepulste elektromagnetische Strahlen verwendet. Die Pulsdauer ist insbesondere kleiner als 10 Sekunden, vorzugsweise kleiner als 1 Sekunde, noch bevorzugter kleiner als 1 Mikrosekunde, am bevorzugtesten kleiner als 1 Nanosekunde, am allerbevorzugtesten kleiner als 1 Pikosekunde.

Ziel des gepulsten Betriebs der Debond-Strahlung ist die rasche, lokale, punktuelle Erwärmung der Temporärbondschicht, sodass die metallische Temporärbondschicht bevorzugt sublimiert, weniger bevorzugt zuerst aufgeschmolzen wird und dann in die Dampfphase übergeht.

Durch Lenkung des Debond-Strahls kann das Temperaturprofil, insbesondere der Temperaturgradient beeinflusst werden, mit welchem die Resublimation bzw. die Kondensation und Erstarrung der aufgelösten Temporärbondschicht zielgerichtet lokal örtlich festgelegt wird.

Entsprechend kann die Resublimation bzw. Kondensation und Erstarrung der Temporärbondschicht ebenfalls durch die Lenkung des Debond-Strahls festgelegt werden.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Fig. 1: eine schematische Skizze eines erfindungsgemäßen Substratstapels in einer ersten Ausführungsform,
- Fig. 2: eine schematische Skizze eines erfindungsgemäßen Substratstapels in einer zweiten Ausführungsform beim Debonden, und
- Fig. 3a-3c: schematische Skizzen von Trägersubstraten in unterschiedlichen Ausführungsformen.

In den Figuren sind gleiche Bauteile oder Bauteile mit der gleichen Funktion mit den gleichen Bezugszeichen gekennzeichnet. Alle Skizzen können zu Darstellungszwecken überzogen gezeichnet sein, somit müssen die Figuren nicht die Proportionen der tatsächlichen Ausführungsformen aufweisen.

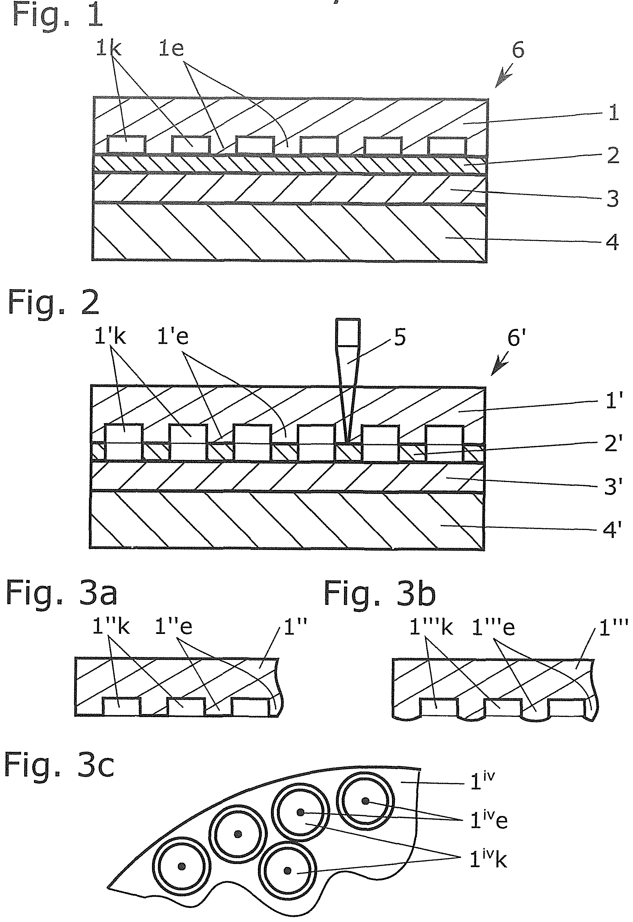

Fig. 1 stellt eine schematische Skizze eines erfindungsgemäßen Substratstapels 6 dar. Der Substratstapel 6 weist ein strukturiertes Trägersubstrat 1, eine, insbesondere metallische, Temporärbondschicht 2, eine Schutzschicht 3 und ein Produktsubstrat 4 auf.

In dieser Ausführungsform wird die Temporärbondschicht 2 als Metallisierung vollflächig auf die dargestellte Schutzschicht 3, welche eine atomar- oder molekular-dünne Barriereschicht sein kann, aufgebracht.

Fig. 2 stellt eine schematische Skizze eines anderen erfindungsgemäßen Substratstapels 6` beim Debonden dar. In dieser Ausführungsform des Substratstapels 6` wurde die Metallisierung 2` lediglich an Erhebungen l'e des Trägersubstrats 1' aufgebracht, sodass die Metallisierung 2' lediglich gezielte Teilflächen der Temporärbondschicht darstellt. Mit anderen Worten wurde die Temporärbondschicht 2` inselartig aufgebracht. Die Schutzschicht 3' trennt das Produktsubstrat 4' von der metallischen Temporärbondschicht 2'.

Ein Debond-Strahl 5 trifft an einer Stelle auf die auf der Erhebung l'e aufgebrachte Temporärbondschicht 2` durch das Trägersubstrat 1 `.

Die Bewegung der Temporärbondschicht 2' in die umliegenden Kavitäten l'k des Trägersubstrats 1 ` wird nicht dargestellt. Die Konvergenz des Debond-Strahls 5 symbolisiert sowohl die zielgerichtete Ablenkung des Debond-Strahls 5 als auch die Fokussierung.

Fig. 3a stellt eine weitere erfindungsgemäße Ausführungsform des insbesondere transparenten Trägersubstrats 1" dar. Das Trägersubstrat l" weist eine Vielzahl von Erhebungen 1"e auf, welche sowohl das nicht dargestellte Produktsubstrat stützen können als auch die Kontaktstelle für die nicht dargestellte Temporärbondschicht bilden.

Die Erhebungen 1"e können linien- oder rasterförmig am Trägersubstrat, insbesondere gleichmäßig, verteilt sein, um eine gleichmäßige Kraftaufnahme der Bearbeitungskräfte ermöglichen zu können. Zwischen den Erhebungen 1"e befinden sich Kavitäten 1"k des Trägersubstrats 1".

Nicht dargestellt sind Einlagerungen der Reste der Temporärbondschicht nach der Resublimation bzw. der Kondensation und Erstarrung.

Fig. 3b stellt eine andere erfindungsgemäße Ausführungsform des insbesondere transparenten Trägersubstrats 1‴ dar. Das Trägersubstrat 1‴ weist eine Vielzahl von Erhebungen 1‴e auf, welche sowohl das nicht dargestellte Produktsubstrat stützen können als auch die Kontaktstelle für die nicht dargestellte Temporärbondschicht bilden. In dieser Ausführungsform des Trägersubstrats 1‴ besitzen die Erhebungen 1‴e konvexe Oberflächen, sodass eine Punktkontaktierung insbesondere mit dem nicht dargestellten Produktsubstrat ermöglicht wird. Im Vergleich zur Ausführungsform in Fig. 3a verkleinern sich wegen der Kapillarwirkung der konvexen Erhebungen 1‴e die wirksamen Flächen der nicht dargestellten Temporärbondschicht. Somit kann einerseits ein Materialersparnis bei der Temporärbondschicht erzielt werden. Andererseits kann durch die Verkleinerung der Stützflächen ein effektiveres Debonden erreicht werden.

Fig. 3c stellt eine weitere erfindungsgemäße Ausführungsform des insbesondere transparenten Trägersubstrats 1^{IV} dar. Das Trägersubstrat 1^{IV} besitzt eine Vielzahl von Erhebungen 1^{IV} e, welche sowohl das nicht dargestellte Produktsubstrat stützen können als auch die Kontaktstelle, für die nicht dargestellte Temporärbondschicht bilden. In dieser Ausführungsform 1^{IV} des Trägersubstrats sind die Erhebungen 1^{IV} e punktförmig. Sie werden von Kavitäten 1^{IV} k umgeben. Besonders vorteilhaft ist in dieser Ausführungsform die gleichmäßige Verteilung der Erhebungen 1^{IV} e auf dem Trägersubstrat 1^{IV}, wobei der Traganteil im Vergleich zu den anderen Ausführungsformen 3a und 3b geringer ausfallen kann.

### Bezugszeichenliste

- 1, 1', 1", 1‴, 1^{IV}: Trägersubstrat
- 1"e, 1‴e, 1^{IV}e: Erhebungen
- 1"k, 1‴k ,1^{IV}k: Kavitäten
- 2, 2': Temporärbondschicht
- 3, 3': Schutzschicht
- 4, 4': Produktsubstrat
- 5: Debondstrahlung
- 6, 6': Substratstapel

## Patentansprüche

1. Verfahren zum temporären Bonden eines Produktsubstrats (4, 4') mit einem Trägersubstrat (1, 1', 1", 1‴, 1^{IV}), aufweisend mindestens die folgenden Schritte:
- Herstellung einer metallisierten Temporärbondschicht (2, 2') am Produktsubstrats (4, 4') und/oder am Trägersubstrat (1, 1', 1", 1‴, 1^{IV}),
- Bonden des Produktsubstrats (4, 4') mit dem Trägersubstrat (1, 1', 1", 1‴, 1^{IV}) an der metallisierten Temporärbondschicht (2, 2'),
**dadurch gekennzeichnet, dass** das Trägersubstrat (1, 1', 1", 1‴, 1^{IV}) strukturiert ausgebildet ist, wobei das Trägersubstrat (1, 1', 1", 1‴, 1^{IV}) Erhebungen (1"e, 1‴e, 1^{IV}e) und Kavitäten (1"k, 1‴k ,1^{IV}k) aufweist, wobei sich die Erhebungen (1"e, 1‴e, 1^{IV}e) mit dem Produktsubstrat (4, 4') über metallische Kontakte stabil verbinden und die Kavitäten (1"k, 1‴k ,1^{IV}k) zwischen den Erhebungen (1"e, 1‴e, 1^{IV}e) angeordnet sind.

2. Verfahren nach Anspruch 1, wobei die Temporärbondschicht (2) vollflächig hergestellt wird, insbesondere auf einer Schutzschicht (3, 3') auf dem Produktsubstrat (4, 4').

3. Verfahren nach Anspruch 1, wobei die Temporärbondschicht (2') stellenweise hergestellt wird, bevorzugt an Erhebungen (1"e, 1‴e, 1^{IV}e) des Trägersubstrats (1', 1", 1‴, 1^{IV}).

4. Verfahren nach mindestens einem der vorhergehenden Ansprüche, wobei eine Schutzschicht (3, 3') auf das Produktsubstrat (4, 4') aufgebracht wird bevor die Herstellung der metallisierten Temporärbondschicht (2, 2') am Produktsubstrats (4, 4') und/oder am Trägersubstrat (1, 1', 1", 1‴, 1^{IV}) erfolgt.

5. Verfahren nach mindestens einem der vorhergehenden Ansprüche, wobei das Bonden thermisch erfolgt.

6. Substratstapel (6, 6') hergestellt mit einem Verfahren nach mindestens einem der vorhergehenden Ansprüche, aufweisend ein Produktsubstrat (4, 4') und ein Trägersubstrat (1, 1', 1", 1‴, 1^{IV}), wobei das Produktsubstrat (4, 4') und des Trägersubstrat (1, 1', 1", 1‴, 1^{IV}) durch eine metallisierte Temporärbondschicht (2, 2') verbunden sind, **dadurch gekennzeichnet, dass** das Trägersubstrat (1, 1', 1", 1‴, 1^{IV}) strukturiert ausgebildet ist, wobei das Trägersubstrat (1, 1', 1", 1‴, 1^{IV}) Erhebungen (1"e, 1‴e, 1^{IV}e) und Kavitäten (1"k, 1‴k ,1^{IV}k) aufweist, wobei sich die Erhebungen (1"e, 1‴e, 1^{IV}e) mit dem Produktsubstrat (4, 4') über metallische Kontakte stabil verbinden und die Kavitäten (1"k, 1‴k ,1^{IV}k) zwischen den Erhebungen (1"e, 1‴e, 1^{IV}e) angeordnet sind.

7. Vorrichtung zum temporären Bonden eines Produktsubstrats (4, 4') mit einem Trägersubstrat (1, 1', 1", 1‴, 1^{IV}) mit einem Verfahren nach mindestens einem der vorhergehenden Ansprüche, wobei
- eine metallisierte Temporärbondschicht (2, 2') am Produktsubstrats (4, 4') und/oder am Trägersubstrat (1, 1', 1", 1‴, 1^{IV}) herstellbar ist,
- das Produktsubstrat (4, 4') mit dem Trägersubstrat (1, 1', 1", 1‴, 1^{IV}) an der metallisierten Temporärbondschicht (2, 2') bondbar ist.

8. Verfahren zum Debonden eines Produktsubstrats (4, 4') von einem Trägersubstrat (1, 1', 1", 1‴, 1^{IV}), wobei das Produktsubstrat (4, 4') und das Trägersubstrat (1, 1', 1", 1‴, 1^{IV}) über eine metallisierte Temporärbondschicht (2, 2') mit einem Verfahren gemäß mindesten einem der Ansprüche 1 bis 5 verbunden sind und einen Substratstapel (6, 6') bilden, aufweisend mindestens die folgenden Schritte:
- Aufnahme und Befestigung des Substratstapels (6, 6') auf einem Substrathalter,
- Fokussierung einer Debondstrahlung (5), insbesondere eines Laserstrahls, durch das Trägersubstrat auf die metallisierte Temporärbondschicht (2, 2') und dadurch Aufschmelzung, Verdampfung und/oder Sublimierung der metallisierten Temporärbondschicht (2, 2'),
- Ablösung des Produktsubstrats (4, 4') vom Trägersubstrat (1, 1', 1", 1‴, 1IV).

9. Verfahren nach Anspruch 8, wobei die Wärmeleitfähigkeit des Trägersubstrates (1, 1', 1", 1‴, 1^{IV}) zwischen 0,1 W/(m*K) und 5000 W/(m*K), vorzugsweise zwischen 1 W/(m*K) und 2500 W/(m*K), noch bevorzugter zwischen 0,5 W/(m*K) und 1000 W/(m*K) liegt.

10. Verfahren nach mindestens einem der vorhergehenden Ansprüche 8 bis 9, wobei der Substratstapel (6, 6') durch eine Heizung und/oder Kühlung geheizt und/oder gekühlt wird.

11. Verfahren nach mindestens einem der vorhergehenden Ansprüche 8 bis 10, wobei die Debondstrahlung (5) gepulst auf die metallisierte Temporärbondschicht (2, 2') fokussiert wird.

12. Verfahren nach mindestens einem der vorhergehenden Ansprüche 8 bis 11, wobei ein Energieeintrag der Debondstrahlung (5) in die metallisierte Temporärbondschicht (2, 2') gemessen wird, und eine Strahlungsleistung der Debondstrahlung (5) geregelt wird.

13. Verfahren nach mindestens einem der vorhergehenden Ansprüche 8 bis 12, wobei die aufgeschmolzene und verdampfte und/oder sublimierte metallisierte Temporärbondschicht (2, 2') vor der Ablösung des Produktsubstrats (4, 4') vom Trägersubstrat (1, 1', 1", 1‴, 1^{IV}) in Kavitäten (1k, 1'k,1"k, 1‴k,1^{IV}k) kondensiert und erstarrt und/oder resublimiert.

14. Vorrichtung zum Debonden eines Produktsubstrats (4, 4') von einem Trägersubstrat (1, 1', 1", 1‴, 1^{IV}) mit einem Verfahren nach mindestens einem der vorhergehenden Ansprüche 8 bis 13, wobei das Produktsubstrat (4, 4') und das Trägersubstrat (1, 1', 1", 1‴, 1^{IV}) über eine metallisierte Temporärbondschicht (2, 2') verbunden sind und einen Substratstapel (6, 6') bilden, wobei die Vorrichtung zumindest aufweist:
- einen Substrathalter zur Aufnahme und Befestigung des Substratstapels (6, 6'),
- eine Strahlungsquelle zur Fokussierung einer Debondstrahlung (5), insbesondere eines Laserstrahls, durch das Trägersubstrat auf die metallisierte Temporärbondschicht (2, 2') und dadurch Aufschmelzung, Verdampfung und/oder Sublimierung der metallischen Temporärbondschicht (2, 2'),
- Ablösemittel zur Ablösung des Produktsubstrats (4, 4') vom Trägersubstrat (1, 1', 1", 1‴, 1^{IV}).

## Claims

1. A method for the temporary bonding of a product substrate (4, 4') with a carrier substrate (1, 1', 1", 1"', 1^{IV}), comprising at least the following steps:
- production of a metallised temporary bonding layer (2, 2') on the product substrate (4, 4') and/or on the carrier substrate (1, 1', 1", 1"', 1^{IV}),
- bonding of the product substrate (4, 4') to the carrier substrate (1, 1', 1", 1"', 1^{IV}) at the metallised temporary bonding layer (2, 2'),
**characterised in that** the carrier substrate (1, 1', 1", 1"', 1^{IV}) is constituted structured, wherein the carrier substrate (1, 1', 1", 1‴, 1^{IV}) comprises elevations (1"e, 1‴e, 1^{IV}e) and cavities (1"k, 1‴k, 1^{IV}k), wherein the elevations (1"e, 1‴e, 1^{IV}e) are joined stably to the product substrate (4, 4') via metallic contacts and the cavities (1"k, 1‴k, 1^{IV}k) are arranged between the elevations (1"e, 1‴e, 1^{IV}e).

2. The method according to claim 1, wherein the temporary bonding layer (2) is produced over the full surface, in particular on a protective layer (3, 3') on the product substrate (4, 4').

3. The method according to claim 1, wherein the temporary bonding layer (2') is produced in places, preferably on elevations (1"e, 1‴e, 1^{IV}e) of the carrier substrate (1', 1", 1‴, 1^{IV}).

4. The method according to at least one of the preceding claims, wherein the protective layer (3, 3') is applied on the product substrate (4, 4') before the production of the metallised temporary bonding layer (2, 2') on the product substrate (4, 4') and/or on the carrier substrate (1, 1', 1", 1"', 1^{IV}).

5. The method according to at least one of the preceding claims, wherein the bonding takes place thermally.

6. A substrate stack (6, 6') produced with a method according to at least one of the preceding claims, comprising a product substrate (4, 4') and a carrier substrate (1, 1', 1", 1"', 1^{IV}), wherein the product substrate (4, 4') and the carrier substrate (1, 1', 1", 1‴, 1^{IV}) are joined by a metallised temporary bonding layer (2, 2'), **characterised in that** the carrier substrate (1, 1', 1", 1‴, 1^{IV}) is constituted structured, wherein the carrier substrate (1, 1', 1", 1‴, 1^{IV}) comprises elevations (1"e, 1‴e, 1^{IV}e) and cavities (1"k, 1‴k, 1^{IV}k), wherein the elevations (1"e, 1‴e, 1^{IV}e) are joined stably with the product substrate (4, 4') via metallic contacts and the cavities (1"k, 1‴k, 1^{IV}k) are arranged between the elevations (1"e, 1‴e, 1^{IV}e).

7. A device for the temporary bonding of a product substrate (4, 4') with a carrier substrate (1, 1', 1", 1"', 1^{IV}) using a method according to at least one of the preceding claims, wherein
- a metallised temporary bonding layer (2, 2') can be produced on the product substrate (4, 4') and/or on the carrier substrate (1, 1', 1", 1‴, 1^{IV}),
- the product substrate (4, 4') can be bonded with the carrier substrate (1, 1', 1", 1"', 1^{IV}) at the metallised temporary bonding layer (2, 2').

8. A method for the debonding of a product substrate (4, 4') from a carrier substrate (1, 1', 1", 1‴, 1^{IV}), wherein the product substrate (4, 4') and the carrier substrate (1, 1', 1", 1"', 1^{IV}) are joined via a metallised temporary bonding layer (2, 2') by a method according to at least one of claims 1 to 5 and form a substrate stack (6, 6'), comprising at least the following steps:
- mounting and fixing of the substrate stack (6, 6') on a substrate holder,
- focusing of debonding radiation (5), in particular a laser beam, through the carrier substrate onto the metallised temporary bonding layer (2, 2') and thus melting, evaporating and/or sublimating the metallised temporary bonding layer (2, 2').
- release of the product substrate (4, 4') from the carrier substrate (1, 1', 1", 1"', 1^{IV}).

9. The method according to claim 8, wherein the thermal conductivity of the carrier substrate (1, 1', 1", 1‴, 1^{IV}) lies between 0.1 W/(m*K) and 5000 W/(m*K), preferably between 1 W/(m*K) and 2500 W/(m*K), still more preferably between 0.5 W/(m*K) and 1000 W/(m*K).

10. The method according to at least one of preceding claims 8 to 9, wherein the substrate stack (6, 6') is heated and/or cooled by means of a heating system and/or cooling system.

11. The method according to at least one of preceding claims 8 to 10, wherein the debonding radiation (5) is focused in a pulsed manner onto the metallised temporary bonding layer (2, 2').

12. The method according to at least one of preceding claims 8 to 11, wherein an energy input of the debonding radiation (5) into the metallised temporary bonding layer (2, 2') is measured and a radiated power of the debonding radiation (5) is regulated.

13. The method according to at least one of preceding claims 8 to 12, wherein the melted and evaporated and/or sublimated metallised temporary bonding layer (2, 2') condenses and solidifies and/or resublimates in cavities (1k, 1'k, 1"k, 1‴k, 1^{IV}k) before the release of the product substrate (4, 4') from the carrier substrate (1, 1', 1", 1‴, 1^{IV}).

14. A device for the debonding of a product substrate (4, 4') from a carrier substrate (1, 1', 1", 1"', 1^{IV}) by a method according to at least one of preceding claims 8 to 13, wherein the product substrate (4, 4') and the carrier substrate (1, 1', 1", 1"', 1^{IV}) are joined via a metallised temporary bonding layer (2, 2') and form a substrate stack (6, 6'), wherein the device comprises at least:
- a substrate holder for mounting and fixing the substrate stack (6, 6'),
- a radiation source for focusing debonding radiation (5), in particular a laser beam, through the carrier substrate onto the metallised temporary bonding layer (2, 2') and thus melting, evaporating and/or sublimating the metallic temporary bonding layer (2, 2'),
- a release agent for releasing the product substrate (4, 4') from the carrier substrate (1, 1', 1", 1‴, 1^{IV}).

## Revendications

1. Procédé pour la liaison temporaire d'un substrat de produit (4, 4') avec un substrat porteur (1, 1', 1", 1"', 1^{IV}), présentant au moins les étapes suivantes :
- réalisation d'une couche de liaison temporaire métallisée (2, 2') sur le substrat de produit (4, 4') et/ou sur le substrat porteur (1, 1', 1", 1‴, 1^{IV}),
- liaison du substrat de produit (4, 4') avec le substrat porteur (1, 1', 1", 1‴, 1^{IV}) sur la couche de liaison temporaire métallisée (2, 2'),
**caractérisé en ce que**
le substrat porteur (1, 1', 1", 1‴, 1^{IV}) est conçu structuré, dans lequel le substrat porteur (1, 1', 1", 1‴, 1^{IV}) présente des éminences (1"e, 1‴e, 1^{IV}e) et des cavités (1"k, 1‴k, 1^{IV}k), dans lequel les éminences (1"e, 1‴e, 1^{IV}e) sont reliées de manière stable au substrat de produit (4, 4') par des contacts métalliques et les cavités (1"k, 1‴k, 1^{IV}k) sont disposées entre les éminences (1"e, 1‴e, 1^{IV}e).

2. Procédé selon la revendication 1, dans lequel la couche de liaison temporaire (2) est réalisée sur toute la surface, en particulier sur une couche de protection (3, 3') sur le substrat de produit (4, 4').

3. Procédé selon la revendication 1, dans lequel la couche de liaison temporaire (2') est réalisée par endroits, de préférence sur des éminences (1"e, 1‴e, 1^{IV}e) du substrat porteur (1', 1", 1‴, 1^{IV}).

4. Procédé selon au moins l'une des revendications précédentes, dans lequel une couche de protection (3, 3') est appliquée sur le substrat de produit (4, 4') avant la réalisation de la couche de liaison temporaire métallisée (2, 2') sur le substrat de produit (4, 4') et/ou sur le substrat porteur (1, 1', 1", 1"', 1^{IV}).

5. Procédé selon au moins l'une des revendications précédentes, dans lequel la liaison est thermique.

6. Pile de substrats (6, 6') fabriquée avec un procédé selon au moins l'une des revendications précédentes, présentant un substrat de produit (4, 4') et un substrat porteur (1, 1', 1", 1‴, 1^{IV}), dans lequel le substrat de produit (4, 4') et le substrat porteur (1, 1', 1", 1‴, 1^{IV}) sont reliés par une couche de liaison temporaire métallisée (2, 2'),
**caractérisé en ce que**
le substrat porteur (1, 1', 1", 1‴, 1^{IV}) est conçu structuré, dans lequel le substrat porteur (1, 1', 1", 1‴, 1^{IV}) présente des éminences (1"e, 1‴e, 1^{IV}e) et des cavités (1"k, 1‴k, 1^{IV}k), dans lequel les éminences (1"e, 1‴e, 1^{IV}e) sont reliées de manière stable au substrat de produit (4, 4') par des contacts métalliques et les cavités (1"k, 1‴k, 1^{IV}k) sont disposées entre les éminences (1"e, 1‴e, 1^{IV}e).

7. Dispositif pour la liaison temporaire d'un substrat de produit (4, 4') avec un substrat porteur (1, 1', 1", 1"', 1^{IV}) par un procédé selon au moins l'une des revendications précédentes, dans lequel
- une couche de liaison temporaire métallisée (2, 2') peut être réalisée sur le substrat de produit (4, 4') et/ou sur le substrat porteur (1, 1', 1", 1‴, 1^{IV}),
- le substrat de produit (4, 4') avec le substrat porteur (1, 1', 1", 1‴, 1^{IV}) peut être lié sur la couche de liaison temporaire métallisée (2, 2').

8. Procédé pour la dé-liaison d'un substrat de produit (4, 4') d'avec un substrat porteur (1, 1', 1", 1‴, 1^{IV}), dans lequel le substrat de produit (4, 4') et le substrat porteur (1, 1', 1", 1‴, 1^{IV}) sont reliés par une couche de liaison temporaire métallisée (2, 2') par un procédé selon au moins l'une des revendications 1 à 5 et forment une pile de substrats (6, 6'), présentant au moins les étapes suivantes :
- réception et fixation de la pile de substrats (6, 6') sur un support de substrat,
- mise au point d'un rayon de dé-liaison (5), en particulier d'un rayon laser, à travers le substrat porteur sur la couche de liaison temporaire métallisée (2, 2') et ainsi, fonte, vaporisation et/ou sublimation de la couche de liaison temporaire métallisée (2, 2'),
- séparation du substrat de produit (4, 4') du substrat porteur (1, 1', 1", 1‴, 1^{IV}).

9. Procédé selon la revendication 8, dans lequel la conductivité thermique du substrat porteur (1, 1', 1", 1"', 1^{IV}) est entre 0,1 W/(m*K) et 5000 W/(m*K), de préférence entre 1 W/(m*K) et 2500 W/(m*K), plus encore de préférence entre 0,5 W/(m*K) et 1000 W/(m*K).

10. Procédé selon au moins l'une des revendications précédentes 8 à 9, dans lequel la pile de substrats (6, 6') est chauffée par un chauffage et/ou refroidie par un refroidissement.

11. Procédé selon au moins l'une des revendications précédentes 8 à 10, dans lequel le rayon de dé-liaison (5) est mis au point pulsé sur la couche de liaison temporaire (2, 2').

12. Procédé selon au moins l'une des revendications précédentes 8 à 11, dans lequel un apport d'énergie du rayon de dé-liaison (5) dans la couche de liaison temporaire (2, 2') est mesuré et une puissance de rayonnement du rayon de dé-liaison (5) est réglée.

13. Procédé selon au moins l'une des revendications précédentes 8 à 12, dans lequel la couche de liaison temporaire (2, 2') fondue et vaporisée et/ou sublimée est condensée et figée et/ou re-sublimée dans des cavités (1k, 1'k, 1"k, 1"'k, 1^{IV}k) avant la séparation du substrat de produit (4, 4') d'avec le substrat porteur (1, 1', 1", 1‴, 1IV).

14. Dispositif pour la dé-liaison d'un substrat de produit (4, 4') d'avec un substrat porteur (1, 1', 1", 1‴, 1^{IV}) avec un procédé selon au moins l'une des revendications précédentes 8 à 13, dans lequel le substrat de produit (4, 4') et le substrat porteur (1, 1', 1", 1‴, 1^{IV}) sont reliés par une couche de liaison temporaire métallisée (2, 2') et forment une pile de substrats (6, 6'), dans lequel le dispositif présente au moins :
- un support de substrat pour la réception et la fixation de la pile de substrats (6, 6') sur un support de substrat,
- une source de rayonnement pour la mise au point d'un rayon de dé-liaison (5), en particulier d'un rayon laser, à travers le substrat porteur sur la couche de liaison temporaire métallisée (2, 2') et ainsi, fonte, vaporisation et/ou sublimation de la couche de liaison temporaire métallisée (2, 2') ,
- des agents de séparation pour la séparation du substrat de produit (4, 4') d'avec le substrat porteur (1, 1', 1", 1‴, 1^{IV}).
